# EUROPÄISCHE PATENTSCHRIFT

(11) **EP 0 535 408 B1**
(45) Veröffentlichungstag und Bekanntmachung des Hinweises auf die Patenterteilung: **11.06.1997**
(21) Anmeldenummer: 92115319.3
(22) Anmeldetag: 08.09.1992
(51) Int. Cl.: G01R 33/028, H02J 7/00, G01R 1/22

(54) **Vorrichtung zum Erfassen eines Magnetfeldes**
Apparatus for magnetic field detection
Dispositif de détection de champ magnétique

(30) Priorität: 01.10.1991 DE 4132641
(43) Veröffentlichungstag der Anmeldung: 07.04.1993
(73) Patentinhaber: ROBERT BOSCH GMBH, 70442 Stuttgart (DE)
(72) Erfinder: Kutteruf, Karl-Martin, Dipl.-Ing. (FH), W-7311 Neidlingen (DE)

(56) Entgegenhaltungen:
- WO-A-91/07001
- GB-A- 2 117 579
- US-A- 3 771 039
- US-A- 4 634 969
- US-A- 4 847 780

## Beschreibung

### Stand der Technik

Die Erfindung geht aus von einer Vorrichtung zum Erfassen eines Magnetfeldes, die wenigstens eine Spulenanordnung enthält. Eine solche Vorrichtung ist als Stromwandlerzange bekannt, die das Magnetfeld erfaßt, das einen stromdurchflossenen Leiter umgibt. Die Stromwandlerzange gibt ein Signal an eine signalverarbeitende Anordnung ab, die beispielsweise den Strom oder die magnetische Feldstärke ermittelt. Die signalverarbeitende Anordnung ist beispielsweise als Multifunktions-Meßgerät realisiert, das über Leitungen mit der Zange verbindbar ist. Ebenso ist es möglich, daß die Zange unmittelbar eine entsprechende signalverarbeitende Anordnung enthält. Zur Energieversorgung der signalverarbeitenden Anordnung ist bei beweglichen Vorrichtungen im allgemeinen eine Batterie vorgesehen. Neben der signalverarbeitenden Anordnung können weitere elektronische Komponenten, wie beispielsweise ein in der Vorrichtung enthaltener Hallsensor, einen Energiebedarf aufweisen, der ebenfalls im allgemeinen von einer Batterie aufgebracht wird.

Die Batterie ist vorzugsweise als wiederaufladbare Batterie ausgebildet, um den Batterienverbrauch zu reduzieren. Die Einsatzbereitschaft der Vorrichtung zum Erfassen eines Magnetfelds hängt von der Betriebsbereitschaft der Energiequelle ab.

Zur kontinuierlichen Energiebereitstellung sind beispielsweise mehrere auswechselbare Batterien oder ein Batterieladegerät erforderlich, das zumindest zeitweise mit der Zange oder mit dem Multifunktionsmeßgerät zu verbinden ist.

Der Erfindung liegt die Aufgabe zugrunde, die Handhabung einer Stromwandlerzange zu vereinfachen.

Die Aufgabe wird durch die im Hauptanspruch angegebenen Merkmale gelöst.

### Vorteile der Erfindung

Die erfindungsgemäße Stromwandlerzange weist den Vorteil einer vereinfachten Handhabung auf. Erfindungsgemäß ist vorgesehen, daß eine aufladbare Batterie, die zur Energieversorgung einer signalverarbeitenden Anordnung oder anderer elektronischer Komponenten vorgesehen ist, mittels induktiver Energieübertragung aufladbar ist. Vorgesehen ist eine Batterieladeeinrichtung, die einen Strom in eine magnetfelderzeugende Anordnung, beispielsweise einen Stromleiter abgibt, der gleichzeitig als Halterung für die Stromwandlerzange ausgebildet ist, wobei das den Leiter umgebende Magnetfeld in die Spulenanordnung der Vorrichtung eine Spannung induziert, die zu einer induktiven Energieübertragung führt.

Die erfindungsgemäße Stromwandlerzange weist weiterhin den Vorteil einer hohen Verfügbarkeit auf, weil die Batterie allein durch ein ordnungsgemäßes Ablegen der Vorrichtung stets nachgeladen wird.

Vorteilhafte Ausgestaltungen und Verbesserungen der erfindungsgemäßen Stromwandlerzange ergeben sich aus Unteransprüchen.

Besonders einfach sind die Mittel zum Verbinden der Batterie mit der Spulenanordnung als Diode realisierbar. Eine Trennung zwischen der Batterie und dem Signalpfad ist somit gewährleistet, wenn das erwartete, zu messende Signal eine kleinere Amplitude im Vergleich zu dem Signal erreicht, das zur Batterieladung vorgesehen ist.

Eine weitere einfache Ausgestaltung der Mittel zum Verbinden der Spulenanordnung mit der Batterie ist durch einen mechanisch betätigbaren Schalter gegeben.

Eine andere vorteilhafte Ausgestaltung sieht vor, daß der Schalter von der signalverarbeitenden Anordnung betätigbar ist, die in Abhängigkeit von dem empfangenen Signal festlegt, ob der Schalter betätigt wird oder nicht. Das Einschaltsignal für den Schalter kann beispielsweise in Abhängigkeit von der Amplitude oder beispielsweise in Abhängigkeit von der Frequenz des empfangenen Signals ermittelt werden. Vorzugsweise ist der Batterieladeeinrichtung ein Modulator zugeordnet, der das Signal in geeigneter Weis moduliert, wobei in der signalverarbeitenden Anordnung ein zum Modulator korrespondierender Demodulator vorgesehen ist, der das Signal zum Schalter abgibt.

Die Verwendung von Stromwandlerzangen ist von Vorteil, weil der Aufbewahrungsort der Zange mit der magnetfelderzeugenden Anordnung besonders einfach gestaltbar ist, beispielsweise dadurch, daß die magnetfelderzeugende Anordnung entweder als ein Metallbügel realisiert ist, den die Zange umschließt, oder als ein Rohr ausgebildet ist, in welchem mehrere Windungen liegen.

Die Stromwandlerzange ist ebenso geeignet zur Verwendung in anderen induktiven Gebern, die eine Induktivitätsänderung der Sensoranordnung auszuwerten gestatten. Ein solcher Geber ist beispielsweise zum Erfassen einer Lage oder einer Geschwindigkeit vorgesehen.

Weitere vorteilhafte Ausgestaltungen und Verbesserungen der erfindungsgemäßen Stromwandlerzange ergeben sich aus weiteren Unteransprüchen in Verbindung mit der folgenden Beschreibung:

### Zeichnung

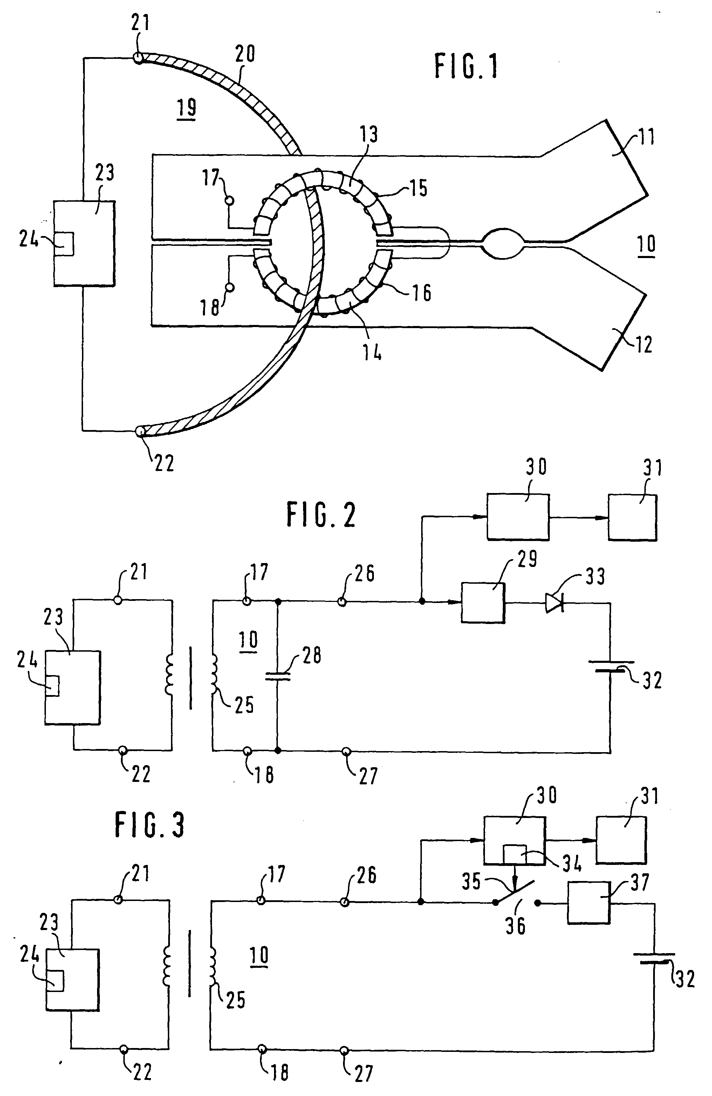

Figur 1 zeigt eine erfindungsgemäße Stromwandlerzange und Figuren 2 sowie 3 zeigen Blockschaltbilder.

In Figur 1 ist eine Stromwandlerzange 10 gezeigt, die zwei gegeneinander bewegliche Hälften 11, 12 enthält. Die Hälften 11, 12 enthalten jeweils magnetisierbare Kerne 13, 14, die jeweils wenigstens eine Wicklung 15, 16 tragen. Die miteinander verbundenen Wicklungen 15, 16 führen zu Anschlüssen 17, 18.

Die Zange 10 umschließt eine magnetfelderzeugende Anordnung 19, die als metallischer Bügel 20 ausgebildet ist. Der Bügel 20 weist an seinen Enden 21, 22 Anschlüsse auf, an die eine Batterieladeeinrichtung 23 angeschlossen ist, die einen Modulator 24 enthält.

Übereinstimmende Teile tragen in allen Figuren dieselben Bezugszeichen.

Figur 2 zeigt ein Blockschaltbild, das der erfindungsgemäßen Vorrichtung zugrundeliegt. Die Zange 10 mit den Anschlüssen 17, 18 ist mit ihrer Ersatzinduktivität 25 eingetragen, die die Kerne 13, 14 mit den Wicklungen 15, 16 aufweist. Zwischen den Anschlüssen 17, 18, die zu weiteren Anschlüssen 26, 27 führen, ist ein Kondensator 28 geschaltet. Am Anschluß 26 sind ein Hochpaß 29 und eine signalverarbeitenden Anordnung 30 angeschlossen. Die Anordnung 30 ist mit einer Anzeige 31 verbunden. Am Anschluß 27 ist eine Batterie 32 angeschlossen, die weiterhin über eine Diode 33 mit dem Hochpaß 29 verbunden ist.

In Figur 3 ist ein weiteres Blockschaltbild gezeigt, das die Zange 10 enthält, wobei in der ebenenfalls enthaltenen signalverarbeitenden Anordnung 30 ein Demodulator 34 gezeigt ist, der ein Schaltsignal 35 an einen Schalter 36 gibt, der mit dem Anschluß 26 verbunden ist. Der Schalter 36 ist weiterhin mit einem Spannungswandler 37 verbunden, der an der Batterie 32 angeschlossen ist.

Die erfindungsgemäße Stromwandlerzange wird anhand der in den Figuren 2 und 3 gezeigten Blockschaltbilder in Verbindung mit Figur 1 näher erläutert:

Die Zange 10 stellt an den Anschlüssen 17, 18 ein Signal bereit, das proportional zu einem sich ändernden Magnetfeld ist, das einen Leiter umgibt, der von den Kernen 13, 14 umgeben wird. Als Leiter ist in Figur 1 beispielsweise der metallische Bügel 20 vorgesehen, der mit der Batterieladeeinrichtung 23 verbunden ist. Das den Bügel 20 umgebende Magnetfeld induziert in die Wicklungen 15, 16 eine Spannung, die an den Anschlüssen 17, 18 abgreifbar ist.

Die an den Anschlüssen 17, 18 auftretenden Signale können beispielsweise der in Figur 2 gezeigten signalverarbeitenden Anordnung 30 zugeleitet werden, die daraus einen Strom ermittelt und das Ergebnis über die Anzeige 31 ausgibt. Die signalverarbeitende Anordnung 30 ist beispielsweise in einem separaten Gerät untergebracht, das über Verbindungsleitungen mit der Zange 10 verbunden ist. In Figur 2 sind deshalb die Anschlüsse 26, 27 eingetragen, die andeuten sollen, daß zwischen der Zange 10 und der signalverarbeitenden Anordnung 30 eine Verbindung herzustellen ist.

Die signalverarbeitende Anordnung 30 benötigt im allgemeinen eine Stromversorgung, die durch die in Figur 2 gezeigte Batterie 32 vorgenommen wird. Neben der signalverarbeitenden Anordnung 30 können andere elektronische Komponenten vorgesehen sein, die eine elektrische Energie zum Betrieb benötigen. Beispielsweise kann in der in Figur 1 gezeigten Stromwandlerzange 10 an wenigstens einer Trennstelle der Kerne 13, 14 ein Hallsensor angeordnet sein. Ein solcher Hallsensor ermöglicht die Erfassung eines zeitlich konstanten Magnetfeldes, das einen gleichstromdurchflossenen Leiter umgibt. Die Energieversorgung des Hallsensors wird ebenfalls durch die Batterie 32 vorgenommen, wobei zusätzliche Energieversorgungsleitungen erforderlich sind, die in den Figuren 1, 2 und 3 nicht eingetragen sind. Ein vergleichsweise hoher Energieverbrauch würde zu einem entsprechend hohen Batterieverbrauch führen. Es ist deshalb die Batterie 32 als wiederaufladbare Batterie ausgestaltet. Anstelle eines herkömmlichen Batterieladegerätes ist erfindungsgemäß vorgesehen, die Energie zum Laden der Batterie induktiv über die vorhandene Spulenanordung 13, 14, 15, 16 einzukoppeln.

Zum Laden der Batterie 32 ist die magnetfelderzeugende Anordnung 19 vorgesehen, die beispielsweise als metallischer Bügel 20 ausgebildet ist, an den die Zange 10 klemmbar ist. Der Bügel 20 ist gleichzeitig als Aufbewahrungsort der Zange 10 vorgesehen. Die Batterieladeeinrichtung 23, die an den Anschlüssen 21, 22 des Bügels 20 angeschlossen ist, erzeugt im Bügel 20 einen Wechselstrom, dessen Magnetfeld in der Spulenanordnung 13, 14, 15, 16 eine entsprechende Wechselspannung erzeugt. Ein Ersatzschaltbild der Kopplung ist in Figur 2 gezeigt, wobei eine transformatorische Kopplung zugrunde liegt, welche die Ersatzinduktivität 25 der Spulenanordnung 13, 14, 15, 16 sowie die nicht näher bezeichnete Induktivität der magnetfelderzeugenden Anordnung 19 enthält.

Anstelle des Bügels kann auch eine andere Leiteranordnung vorgesehen sein. Geeignet ist beispielsweise eine Spule, die vorzugsweise mehrere Windungen aufweist.

Bei der Energieübertragung können sowohl die Signalamplitude an den Anschlüssen 17, 18 als auch die Frequenz des Signals in Abhängigkeit von den erwarteten Werten der auszumessenden Magnetfelder festgelegt werden. Beispielsweise ist es möglich, die Frequenz des Wechselstroms, der zur Energieübertragung vorgesehen ist, höher zu legen als die höchste Frequenz des auszumessenden Magnetfeldes. In dieser Ausgestaltung sind als Mittel zum Verbinden der Batterie 32 mit der Spulenanordnung 13, 14, 15, 16 über die Anschlüsse 17, 26 der Hochpaß 29 ausreichend, der die Diode 33 nachgeschaltet ist. Der Hochpaß 29 trennt die Energiequelle 32 vom Signalpfad, der zur signalverarbeitenden Anordnung 30 führt, bei niedrigen Frequenzen ab. Die Diode 33 bewirkt eine Gleichrichtung des Ladestroms. In einer einfacheren Ausgestaltung kann der Hochpaß 29 entfallen. In diesem Fall bewirkt die Diode 33 zusätzlich eine Ankopplung an der Batterie 32 von dem Signalpfad. Die Batterie 32 wird dann geladen, wenn die an den Anschlüssen 17, 18 liegende Spannung oberhalb der Batterie- spannung zuzüglich einer Durchlaßspannung der Diode 33 liegt.

In einer Ausgestaltung der erfindungsgemäßen Stromwandlerzange ist der Spulenanordnung 13, 14, 15, 16 der Kondensator 28 parallel geschaltet, so daß ein Resonanzkreis entsteht. Die Übertragungsfrequenz für die Energieübertragung ist in diesem Fall zweckmäßig auf die Resonanzfrequenz abzustimmen.

In einer anderen vorteilhaften Ausgestaltung ist der Batterieladeeinrichtung 23 der Modulator 24 zugeordnet, der den von der Batterieladeeinrichtung 23 abgegebenen Strom moduliert.

Geeignet sind Amplituden-, Frequenz-, oder Impulsmodulation. Das modulierte Signal wird im Demodulator 34 demoduliert. Der Demodulator 34 gibt ein Schaltsignal 35 ab, das immer dann auftritt, wenn eine Batterieladung möglich ist. Das Schaltsignal 35 betätigt beispielsweise den Schalter 36, der in einer Ausgestaltung als Mittel zum Verbinden der Batterie 32 mit der Spulenanordnung 13, 14, 15, 16 vorgesehen ist. Der in Figur 3 gezeigte Schalter führt zum Spannungswandler 37, der an der Batterie 32 angeschlossen ist. Der Spannungswandler 37 kann beispielsweise dann vorgesehen sein, wenn die in die Spulenanordnung 13, 14, 15, 16 induzierte Spannung während des Batterieladens auf einem zu niedrigen oder zu hohen Niveau in Bezug auf die Spannung der Batterie 32 liegt. Der Spannungswandler 37 ist beispielsweise als getakteter Hoch- oder Tiefsetzer ausgebildet. Insbesondere bei einem getakteten Betrieb des Spannungswandlers 37 ist die Ausgestaltung des Mittels zum Verbinden der Batterie 32 mit der Spulenanordnung 13, 14, 15, 16 als Schalter 36 zweckmäßig, weil Störspannungen von der signalverarbeitenden Anordung 30 ferngehalten werden.

## Patentansprüche

1. Stromwandlerzange (10), mit wenigstens einer Spulenanordnung (13, 14, 15, 16), die ein Signal an eine signalverarbeitende Anordnung (30) abgibt, mit einer aufladbaren Batterie (32) zur Energieversorgung elektronischer Komponenten zumindest der signalverarbeitenden Anordnung (30), wobei Mittel (29, 33, 36, 37) zum Verbinden der Batterie (32) mit der Spulenanordnung (13, 14, 15, 16) vorgesehen sind, mit einer Batterieladeeinrichtung (23), die einen Wechselstrom an eine magnetfelderzeugende Anordnung (19) abgibt, und wobei die magnetfelderzeugende Anordnung (19) mit der Spulenanordnung (13, 14, 15, 16) induktiv koppelbar ist, die magnetfelderzeugende Anordnung (19) als Leiteranordnung (20) ausgeführt ist und die Stromwandlerzange (10) mittels zweier gegeneinander beweglicher Hälften (11, 12) an der Leiteranordnung (20) festklemmbar ist, so daß die Leiteranordnung (20) und die Stromwandlerzange (10) induktiv gekoppelt sind.

2. Stromwandlerzange nach Anspruch 1, dadurch gekennzeichnet, daß als Mittel zum Verbinden der Batterie (32) mit der Spulenanordnung (13, 14, 15, 16) eine Diode (33) vorgesehen ist.

3. Stromwandlerzange nach Anspruch 1, dadurch gekennzeichnet, daß als Mittel zum Verbinden der Batterie (32) mit der Spulenanordnung (13, 14, 15, 16) ein Schalter (36) vorgesehen ist.

4. Stromwandlerzange nach Anspruch 3, dadurch gekennzeichnet, daß der Schalter (36) von der signalverarbeitenden Anordnung (30) betätigbar ist.

5. Stromwandlerzange nach einem der Ansprüche 3 oder 4, dadurch gekennzeichnet, daß der Batterieladeeinrichtung (23) ein Modulator (24) zugeordnet ist und daß der signalverarbeitenden Anordnung (30) ein korrespondierender Demodulator (34) zugeordnet ist, der ein Schaltsignal (35) für den Schalter (36) abgibt.

6. Stromwandlerzange nach einem der vorhergehenden Ansprüche, dadurch gekennzeichnet, daß als Mittel zum Verbinden der Batterie (32) mit der Spulenanordnung (13, 14, 15, 16) ein Hochpaß (29) vorgesehen ist.

7. Stromwandlerzange nach einem der vorhergehenden Ansprüche, dadurch gekennzeichnet, daß die Spulenanordnung (13, 14, 15, 16) mit wenigstens einem Kondensator (28) zu einem Schwingkreis ergänzt ist.

8. Stromwandlerzange nach einem der vorhergehenden Ansprüche, dadurch gekennzeichnet, daß die magnetfelderzeugende Anordnung (19) als Bügel ausgebildet ist.

9. Stromwandlerzange nach einem der Ansprüche 1 bis 7, dadurch gekennzeichnet, daß die magnetfelderzeugende Anordnung (19) als Spule ausgebildet ist.

## Claims

1. Clamp-type current transformer (10), having at least one coil arrangement (13, 14, 15, 16) which outputs a signal to a signal-processing arrangement (30), having a rechargeable battery (32) for supplying energy to electronic components, at least of the signal-processing arrangement (30), means (29, 33, 36, 37) being provided for connecting the battery (32) to the coil arrangement (13, 14, 15, 16), having a battery-charging device (23) which outputs an alternating current to a magnetic field-producing arrangement (19), and the magnetic field-producing arrangement (19) being able to be inductively coupled to the coil arrangement (13, 14, 15, 16), the magnetic field-producing arrangement (19) being designed as a conductor arrangement (20) and the clamp-type current transformer (10) being able to be clamped firmly on the conductor arrangement (20) by means of two halves (11, 12) which can move relative to each other, so that the conductor arrangement (20) and the clamp-type current transformer (10) are inductively coupled.

2. Clamp-type current transformer according to Claim 1, characterized in that a diode (33) is provided as the means for connecting the battery (32) to the coil arrangement (13, 14, 15, 16).

3. Clamp-type current transformer according to Claim 1, characterized in that a switch (36) is provided as the means for connecting the battery (32) to the coil arrangement (13, 14, 15, 16).

4. Clamp-type current transformer according to Claim 3, characterized in that the switch (36) can be actuated by the signal-processing arrangement (30).

5. Clamp-type current transformer according to Claim 3 or 4, characterized in that the battery-charging device (23) is assigned a modulator (24) and in that the signal-processing arrangement (30) is assigned a corresponding demodulator (34) which outputs a switching signal (35) for the switch (36).

6. Clamp-type current transformer according to one of the preceding claims, characterized in that a highpass filter (29) is provided as the means for connecting the battery (32) to the coil arrangement (13, 14, 15, 16).

7. Clamp-type current transformer according to one of the preceding claims, characterized in that the coil arrangement (13, 14, 15, 16) is supplemented by at least one capacitor (28) to form a tuned circuit.

8. Clamp-type current transformer according to one of the preceding claims, characterized in that the magnetic field-producing arrangement (19) is designed as a bow.

9. Clamp-type current transformer according to one of Claims 1 to 7, characterized in that the magnetic field-producing arrangement (19) is designed as a coil.

## Revendications

1. Dispositif convertisseur d'intensité à pince (10), comprenant
- au moins un dispositif à bobine (13, 14, 15, 16) fournissant un signal à un dispositif (30) de traitement de signal,
- une batterie rechargeable (32) pour l'alimentation en énergie de composants électroniques, au moins ceux du dispositif de traitement de signal (30),
- des moyens (29, 33, 36, 37) pour relier la batterie (32) au dispositif à bobine (13, 14, 15, 16),
- une installation de charge de batterie (23) fournissant un courant alternatif à un dispositif générateur de champ magnétique (19), ce dispositif (19) pouvant être couplé par induction au dispositif à bobine (13, 14, 15, 16), le dispositif (19) étant réalisé sous la forme d'un dispositif conducteur (20) et la pince (10) du dispositif convertisseur de courant se serrant sur le dispositif à conducteur (20) par ses deux moitiés (11, 12) mobiles l'une par rapport à l'autre pour réaliser le couplage inductif entre le dispositif à conducteur (20) et la pince (10) du convertisseur de courant.

2. Dispositif convertisseur de courant à pince selon la revendication 1,
caractérisé en ce que
le moyen pour relier la batterie (32) au dispositif à bobine (13, 14, 15, 16) est une diode (33).

3. Dispositif convertisseur de courant à pince selon la revendication 1,
caractérisé en ce que
le moyen pour relier la batterie (32) au dispositif à bobine (13, 14, 15, 16) est un interrupteur (36).

4. Dispositif convertisseur de courant à pince selon la revendication 3,
caractérisé en ce que
l'interrupteur (36) est actionné par le dispositif de traitement de signal (30).

5. Dispositif convertisseur de courant à pince selon l'une des revendications 3 ou 4,
caractérisé en ce que
le dispositif de charge de batterie (23) comporte un modulateur (24) et le dispositif de traitement de signal (30) comporte un démodulateur (34) correspondant fournissant un signal de commutation (35) à l'interrupteur (36).

6. Dispositif convertisseur de courant à pince selon l'une des revendications précédentes,
caractérisé en ce que
le moyen pour relier la batterie (32) au dispositif à bobine (13, 14, 15, 16 est un filtre passe-haut (29).

7. Dispositif convertisseur de courant à pince selon l'une des revendications précédentes,
caractérisé en ce que
le dispositif à bobine (13, 14, 15, 16) est complété par au moins un condensateur (28) pour former un circuit oscillant.

8. Dispositif convertisseur de courant à pince selon l'une des revendications précédentes,
caractérisé en ce que
le dispositif générateur de champ magnétique (19) est un étrier.

9. Dispositif convertisseur de courant à pince selon l'une des revendications 1 à 7,
caractérisé en ce que
le dispositif générateur de champ magnétique (19) est une bobine.
